# EUROPEAN PATENT APPLICATION

(11) **EP 1 487 105 A1**
(43) Date of publication of application: **15.12.2004**
(21) Application number: 04012652.6
(22) Date of filing: 27.05.2004
(51) Int. Cl.: H03K 17/96

(54) **Promixity switch with integral LED**

(30) Priority: 10.06.2003 JP 2003165488
(71) Applicant: Omron Corporation, Kyoto-shi, Kyoto 600-8530 (JP)
(72) Inventor: Tsugui, Hideshi Omron Corp. 801 Minamifudodo-cho, Shimogyo-ku Kyoto 600-8530 (JP); Kinoshita,Masahiro Omron Corp. 801Minamifudodo-cho, Shimogyo-ku Kyoto-shi Kyoto 600-8530 (JP)
(74) Representative: Kilian, Helmut, Dr.

(57) **Abstract**

A conductor detecting switch is provided in which the occupied area on an operating panel can be reduced and high detection sensitivity to a conductor can be realized even when the occupied area is thus reduced. An electrode provided on a control board, and a control IC chip having an electrostatic capacity detector circuit for detecting electrostatic capacity stored in the electrode are provided on the inner side of an operating panel. On the electrode, an LED, which is a dielectric member, and a dielectric member made of synthetic resin are provided to overlap each other. The control board is attached to the inner side of the operating panel, sandwiching the dielectric member between them.

## Description

### BACKGROUND OF THE INVENTION

### 1. FIELD OF THE INVENTION

This invention relates to a conductor detecting switch capable of detecting approach of a conductor by detecting electrostatic capacity changed by the approach of the conductor.

### 2. DESCRIPTION OF THE RELATED ART

A conductor detecting switch of electrostatic capacity type generally includes a flat electrode and an electrostatic capacity detector circuit for detecting electrostatic capacity of the electrode. For example, the conductor detecting switch is adapted for detecting electrostatic capacity changed by approach of a conductor such as a human finger and thus detecting the approach of the conductor when it approaches. The electrode of such a conductor detecting switch is provided near the inner side of an outer case body or on an operating panel of an electronic device in order to achieve high detection sensitivity to the conductor, as described in Patent Reference 1.

Patent Reference 1: JP-A-8-329804

However, since a pressing touch as in the case of pressing a plunger of a mechanical contact switch is not felt on such a conductor detecting switch, a display part or the like for showing the on/off-state or the like must be provided on the operating panel.

However, since the electrode is provided near the inner side of the operating panel or on the surface of the operating panel, the display part must be attached to a position where the electrode is not provided. Therefore, the electrode and the display panel are arranged in parallel, causing a problem of increase in the occupied area on the operating panel.

### SUMMARY OF THE INVENTION

Thus, in view of the foregoing problem, it is an object of this invention to provide a conductor detecting switch in which the occupied area on an operating panel can be reduced and high detection sensitivity to a conductor can be realized even when the occupied area is thus reduced.

In order to solve the foregoing problem, a conductor detecting switch of this invention includes a flat board and an electrode provided on the board and having a detection surface facing an approaching direction of a conductor as a detection object, and is adapted for detecting electrostatic capacity of the electrode and thus detecting approach of the conductor. In the conductor detecting switch, an electronic component which is a dielectric member is provided on the electrode.

With this structure, since the electronic component (for example, LED or the like) can be provided to overlap the electrode, the switch can be made compact and the occupied area on the operating panel can be reduced. Moreover, since the electronic component on the electrode is caused to function as a dielectric member, high detection sensitivity to a conductor can be realized even when the distance between the operating panel and the electrode is increased.

In the case of providing an electronic component which is a dielectric member on the electrode, a dielectric member different from the electronic component is provided on the outside of the electronic component on the electrode.

With this structure, for example, even when the electronic component is relatively smaller than the electrode, high detection sensitivity can be realized by providing another dielectric member on the outside of the electronic component.

Furthermore, in a preferred embodiment, the board is a printed board and this printed board forms the electrode.

With this structure, the electrode can be prepared by the same process as the process of preparing a circuit line on the board, and the manufacturing process can be significantly simplified, compared with the case of providing and attaching a separate electrode.

Additionally, an LED as the electronic component is provided at a central part of the electrode, and a through-hole capable of housing this LED is provided in the dielectric member so as to cover the outer circumference of the LED.

With this structure, for example, if the dielectric member is a semitransparent or opaque member, light cast from the LED can be enclosed in the through-hole and can be prevented from being diffused in the outer circumferential direction.

Above the through-hole in the dielectric member, a diffusion plate for diffusing the light cast from the LED housed in through-hole is provided.

With this structure, even when the operating panel is transparent, the diffusion plate can evenly diffuse the light cast from the LED.

As a conductor detecting switch according to another embodiment, plural electrodes are provided on a board. Electronic components are provided at the central parts of the electrodes and a single dielectric member is provided on these electrodes.

With this structure, as a single board is attached to an electronic device, plural electrodes can be provided at the same time. Moreover, since it suffices to attach a single dielectric member, the manufacturing process can be simplified.

### BRIEF DESCRIPTION OF THE DRAWINGS

Fig.1 is an exploded perspective view of a conductor detecting switch in an embodiment of this invention.
Fig.2 is an A-A sectional view in the state where the conductor detecting switch of Fig.1 is assembled.
Fig. 3 is a circuit structure diagram of an electrostatic capacity detector circuit in the same embodiment.
Fig. 4 is a view showing the switching state of the switch corresponding to the position of a human finger in the same embodiment.
Fig.5 is a circuit structure diagram of another electrostatic capacity detector circuit.
Fig. 6 is a view showing the switching state of the switch corresponding to the position of a human finger in the case where plural threshold values are provided.
Fig. 7 is an exploded perspective view of a conductor detecting switch in a second embodiment of this invention.
Fig.8 is a B-B sectional view in the state where the conductor detecting switch of Fig.7 is assembled.
Fig.9 is an exploded perspective view of a conductor detecting switch in a third embodiment of this invention.
Fig. 10 is an exploded perspective view of a conductor detecting switch in a fourth embodiment of this invention.
Fig. 11 is an exploded perspective view of the conductor detecting switch in the fourth embodiment, in which a larger electrode is provided.

### DETAILED DESCRIPTION OF THE PREFERRED EMBODIMENTS

### [First Embodiment]

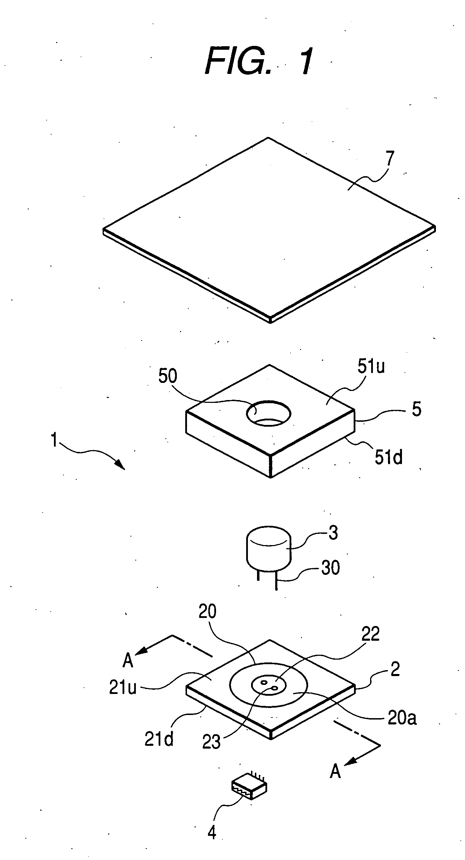

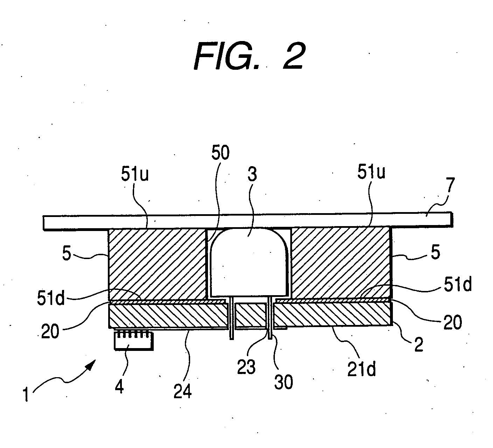

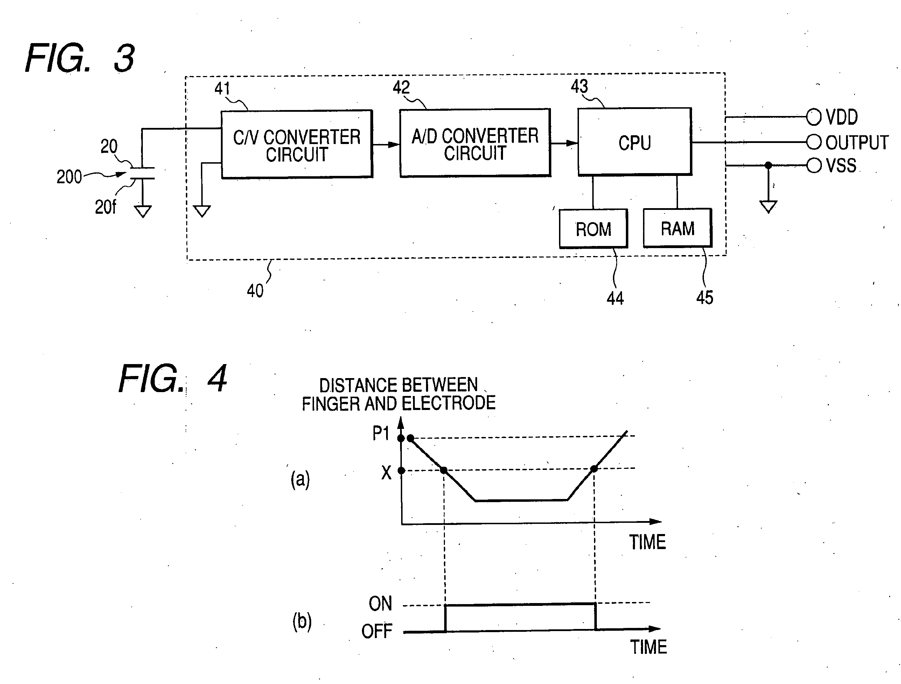

The structure of a conductor detecting switch 1 in a first embodiment of this invention will now be described with reference to the drawings. In this embodiment, Fig.1 shows an exploded perspective view of the conductor detecting switch 1 provided on the inner side of an operating panel 7. Fig.2 shows a sectional view along A-A in Fig.1. Fig.3 shows the structure of an electrostatic capacity detector circuit 40 of a control IC chip 4 mounted on a control board 2.

This conductor detecting switch 1 is attached to a cooking heater, a portable telephone, or other electronic devices having an operating unit. The conductor detecting switch 1 has an electrode 20 having a detection surface 20a facing the approaching direction of a conductor, the control board 2 on which the electrode 20 is printed, the control IC chip 4 having the electrostatic capacity detector circuit 40 (Fig.3) for detecting electrostatic capacity stored in the electrodes 20, and an LED 3, which is a dielectric member on the electrodes 20 on the control board 2, on the inner side of the operating panel 7 formed by a transparent or semitransparent member. Another dielectric member 5 is attached on the electrode 20 and the outside of the LED 3. The structure of this conductor detecting switch 1 will now be described in detail.

The control board 2 is made of a relatively thick flat printed board. On its face side 21u, the circular electrode 20 is formed by etching, evaporation or the like. A circular hollow part 22 that does hot have the detection surface 20a is provided at the central part of the electrode 20, and leg holes 23 for inserting leg parts 30 of the LED 3 therein are provided within the hollow part 22. The leg parts 30 of the LED 3 are inserted into the leg holes 23 to fix the LED 3 in a standing state on the control board 2.

This LED 3 can be lit up and turned off corresponding to the on/off operation of the switch and is made of a synthetic resin or the like having a higher dielectric constant than that of air. The LED 3 has a larger outer diameter than that of the hollow part 22. As the LED 3 is caused to overlap the electrode 20, it functions as a dielectric member to the electrode 20.

Meanwhile, on a rear side 21d of the control board 2, a circuit line 24 (see Fig.2) and the control IC chip 4 are provided. The circuit line 24 is formed by etching, evaporation or the like, like the electrode 20 provided on the face side 21u, and is electrically continued to the electrode 20 and the LED 3 on the face side 21u. The control IC chip 4 has the electrostatic capacity detector circuit 40 shown in Fig.3. It detects electrostatic capacity of the electrode that is changed by approach of a conductor such as a human finger, and thus switches the on/off-state of the switch. The structure including this electrostatic capacity detector circuit 40 will now be described.

In Fig.3, a part surrounded by a broken line shows the structure of the electrostatic capacity detector circuit 40. 20 represents the electrode provided on the control board 2. 20f represents a conductor (human finger or the like) facing and approaching the electrode 20. The electrode 20 and the conductor 20f form a variable capacitor 200. In this electrostatic capacitor detector circuit 40, 41 represents a C/V converter circuit, which detects electrostatic capacity stored in the electrode 20 and outputs a voltage corresponding to the detected electrostatic capacity. 42 represents an A/D converter circuit. It converts an analog voltage signal outputted from the C/V converter circuit 41 to a digital voltage signal. 43 represents a CPU. It switches the on/off-state of the switch on the basis of the signal outputted from the A/D converter circuit 42. 44 represents a ROM. It stores a program for operating the CPU 43. 45 represents a RAM. It stores information related to a threshold value for switching the on/off-state of the switch. As the information related to a threshold value, for example, a threshold value of voltage corresponding to the distance of changing over the switch is stored in the case where electrostatic capacity is converted to voltage information and then outputted by the C/V converter circuit 41.

The dielectric member 5 is made of a material having a higher dielectric constant than that of air, for example, plastics, in order to realize high detection sensitivity to the conductor. The dielectric member 5 has a through-hole 50 vertically penetrating the dielectric member 5, corresponding to the outer shape of the LED 3. Having the LED 3 housed in the through-hole 50, the dielectric member 5 is provided on the electrode 20 with its bottom part 51d in contact with the electrode 20 on the outside of the through-hole 50. The dielectric member 5 is made of an opaque or semitransparent material and thus has a diffusion prevention function to prevent diffusion in the,outer circumferential direction of light cast from the LED 3 housed in the through-hole 50. The dielectric member 5 has a thickness larger than the height of the LED 3 mounted on the control board 2. Having the LED 3 housed on the inner side in the direction of height of the dielectric member 5, the dielectric member 5 has its top part 51u abutted against the inner side of the operating panel 7. The electric member 5 thus has a supporting function to support the control board 2 on the inner side of the operating panel 7 with a fixture, not shown.

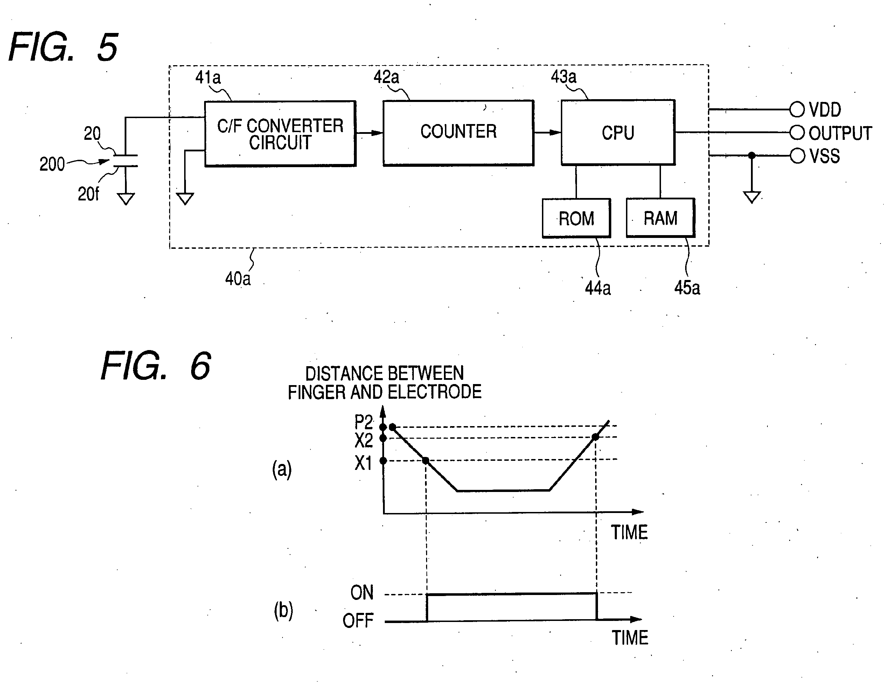

The on/off switching control of the conductor detecting switch 1 constructed as described above will now be described with reference to Fig.4.

In Fig.4, a part (a) shows the switching state of the switch corresponding to the position of a human finger. The vertical axis represents the distance between the human finger and the electrode 20. The horizontal axis represents time. In this part (a) of Fig.4, X represents a threshold value of the distance of switching the on/off-state of the switch, and it is the distance corresponding to the threshold value of voltage stored in the RAM 45. A part (b) of Fig.4 shows the on/off switching state of the switch corresponding to the part (a) of Fig.4.

First, when the finger exists at a position P1 that is far away from the electrode 20, the finger is at the position farther from the electrode 20 than X is, and therefore small electrostatic capacity is detected. Accordingly, a voltage lower than the threshold value is detected. As a result, the switch is off. Then, as the finger gradually approaches the electrode 20, electrostatic capacity stored in the electrode 20 gradually increases on the basis of the finger 's approach. When the conductor becomes closer to the electrode 20 than X is, a voltage higher than the threshold value is detected and the switch is changed over to the on-state. Accordingly, the LED 3 provided on the electrode 20 is lit up. On the other hand, when the finger moves away from the electrode 20, electrostatic capacity stored in the electrode 20 gradually decreases in accordance with the finger's movement. When the conductor becomes farther from the electrode 20 than the position X is, a voltage lower than the threshold value is detected and the switch is changed over to the off-state. Accordingly, the LED 3 provided on the electrode 20 is turned off.

As described above, according to this embodiment, the electrode 20 is provided on the inner side of the operating panel 7, and the LED 3, which is a dielectric electronic component, and the dielectric member 5 made of synthetic resin, which is a different dielectric member from the LED 3, are provided on the electrode 20. Therefore, the LED 3 can overlap the electrode 20. The switch can be made compact and the occupied area on the operating panel can be reduced. Even when the electrode 20 is provided below the operating panel 7 as in this embodiment, high detection sensitivity to the conductor can be realized by the provision of the LED 3, which is a dielectric member, and the dielectric member 5 made of synthetic resin.

Moreover, in this embodiment, since the electrode 20 is formed by using the printed board, the electrode 20 can be prepared by the same process as the process of preparing the circuit line on the control board 2. Therefore, the manufacturing process can be significantly simplified, compared with the case of newly preparing and attaching the electrode 20 onto the board.

Furthermore, since the LED 3 is mounted on the electrode 20 and the semitransparent or opaque dielectric member 5 having the through-hole 50 covers the outer circumferential part of the LED 3, the light cast from the LED 3 can be prevented from being diffused in the outer circumferential direction.

This invention is not limited to the above-described embodiment and various changes can be implemented.

For example, while the C/V converter circuit 41 and the A/D converter circuit 42 are used to constitute the electrostatic capacity detector circuit 40 in the above-described embodiment, a structure as shown in Fig.5 may be employed.

In Fig. 5, as in Fig. 3, a part surrounded by a broken line represents an electrostatic capacity detector circuit 40a, and 20 represents an electrode provided on the control board 2. 20f represents a conductor (human finger or the like) facing and approaching the detection surface 20a of the electrode 20. The electrode 20 and the conductor 20f form a variable capacitor 200. In this electrostatic capacity detector circuit 40a, 41a is a C/F converter circuit, which detects electrostatic capacity stored in the electrode 20 and outputs a frequency corresponding to the detected electrostatic capacity. 42a is a counter. It counts the wave number corresponding to the frequency outputted from the C/F converter circuit 41a. 43 is a CPU. It switches the on/off-state of the switch on the basis of the signal outputted from the counter 42a. 44a is a ROM. It stores a program for operating the CPU 43a. 45a is a RAM. It stores information related to a threshold value for switching the on/off-state of the switch. As for the information related to the threshold value, a counter value of frequency corresponding to the switch changeover distance is stored as the threshold value.

While one threshold value corresponding to X in Fig.4 is used as the threshold value stored in the RAM 45 in the first embodiment, the threshold value is not limited to this. Two different threshold values may be provided to switch the on/off-state of the switch. Fig.6 shows the on/off control of the switch in the case where these two threshold values are provided.

Fig.6 corresponds to Fig.4. A part (a) of Fig.6 shows the relation between the position of a human finger and the threshold values. The vertical axis represents the distance between the human finger and the electrode 20. The horizontal axis represents time. In the part (a) of Fig.6, X1 and X2 represents the threshold values of the distance for switching the on/off-state of the switch. These are the threshold values of voltage stored in the RAMs 45, 45a or the threshold values of the distance corresponding to the counter value of frequency. A part (b) of Fig.6 shows the on/off switching state of the switch corresponding to the part (a) of Fig.6.

In Fig.6, when the finger exists at a position P2 that is far away from the electrode 20, the finger is at the position farther from the electrode 20 than the positions of the threshold values are. Therefore, small electrostatic capacity and a small count value of frequency corresponding to the electrostatic capacity are detected, and the switch is off. Then, as the finger gradually approaches the electrode 20, electrostatic capacity stored in the electrode 20 gradually increases. When the finger becomes closer to the electrode 20 than X1 is, which is closer to the electrode than X2 is, a count value of frequency larger than the threshold value is detected and the switch is changed over to the on-state.

On the other hand, when the finger moves away from the electrode 20, electrostatic capacity stored in the electrode 20 gradually decreases in accordance with the finger 's movement. When the conductor becomes farther from the electrode 20 than the position X2 is, which is farther from the electrode than X1 is, a count value smaller than the threshold value is detected and the switch is changed over to the off-state. Accordingly, the LED 3 provided on the electrode 20 is turned off. As the two different threshold values are provided in this manner, chattering that occurs when the finger exists near the positions of the threshold values can be prevented.

### [Second Embodiment]

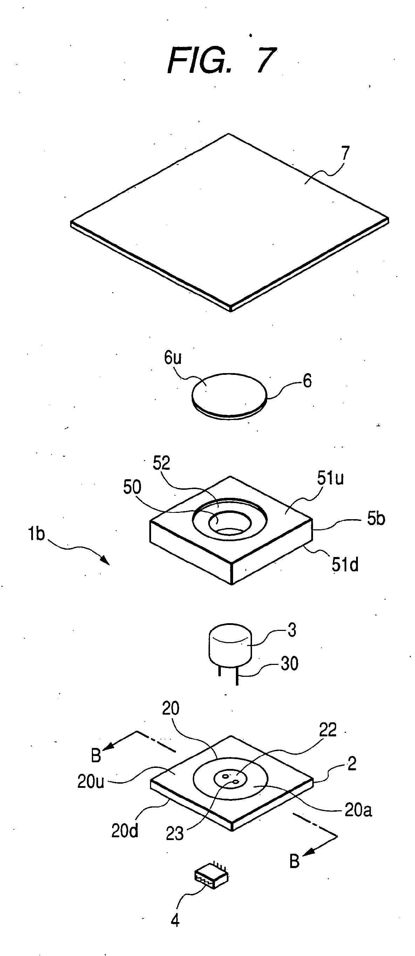

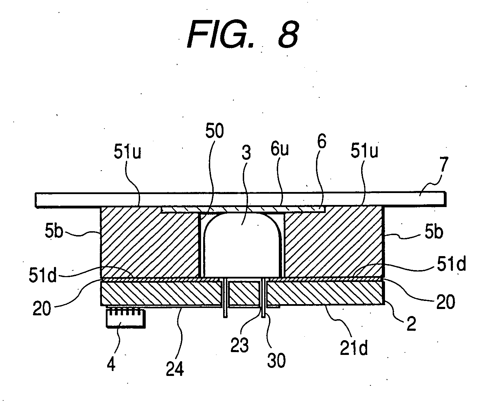

Now, the structure of a conductor detecting switch 1b in a second embodiment of this invention will be described with reference to Figs.7 and 8. Fig.7 is an exploded perspective view of the conductor detecting switch 1b. Fig.8 is a sectional view along B-B in Fig.7. In the conductor detecting switch 1b in the second embodiment, a recess part 52 is provided on the top of the dielectric member 5 of the first embodiment so that a diffusion plate 6 for diffusing light cast from an LED 3 can be mounted therein. In this embodiment, the elements denoted by the same numerals and symbols as in the first embodiment have the same structures as in the first embodiment.

The diffusion plate 6 is formed by a disc-shaped frosted glass that diffuses the light cast from the LED 3, and is mounted in the recess part 52 provided on the top of a through-hole 50 in a dielectric member 5b. A top part 51u of the dielectric member 5b and a top part 6u of the diffusion plate 6 are made coincident with each other, so that the dielectric member 5b and the diffusion plate 6 are flush with each other and adhered to the inner side of an operating panel 7.

With this structure, even if the operating panel 7 is transparent, the diffusion plate 6 can evenly diffuse the light cast from the LED 3.

### [Third Embodiment]

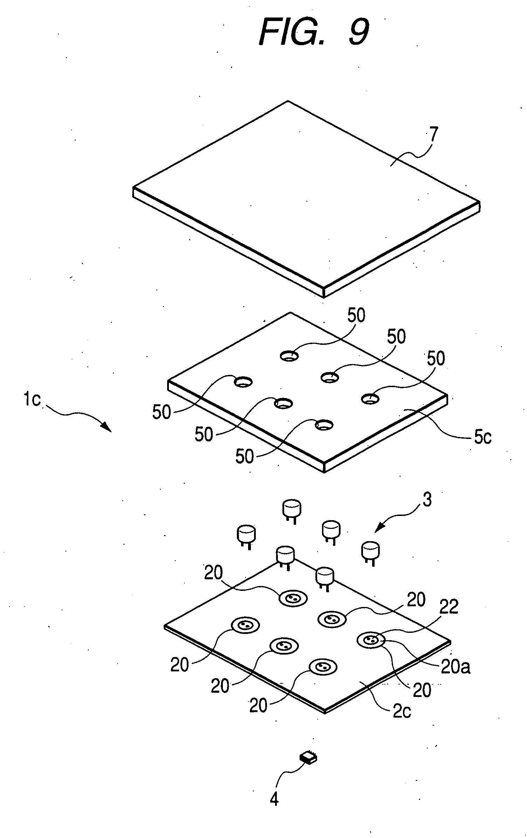

A third embodiment of this invention will now be described with reference to Fig.9. In a conductor detecting switch 1c in this embodiment, plural electrodes 20 are provided on a control board 2c formed by a printed board, and hollow parts 22 are provided at the central parts of the electrodes 20 so that LEDs 3 are mounted therein, as in the first embodiment. Plural through-holes 50 corresponding to the LEDs 3 are provided in a dielectric member 5c, and the dielectric member 5c is mounted on the control board 2c. Also in the third embodiment, the elements denoted by the same numerals and symbols as in the first embodiment have the same structures as in the first embodiment.

with this structure, a large number of electrodes 20 can be prepared at a time and the manufacturing process for the electrodes 20 can be significantly simplified. Moreover, since the single dielectric member 5c is mounted on the control board 2c, the mounting process for the dielectric member 5c can be simplified, too.

### [Fourth Embodiment]

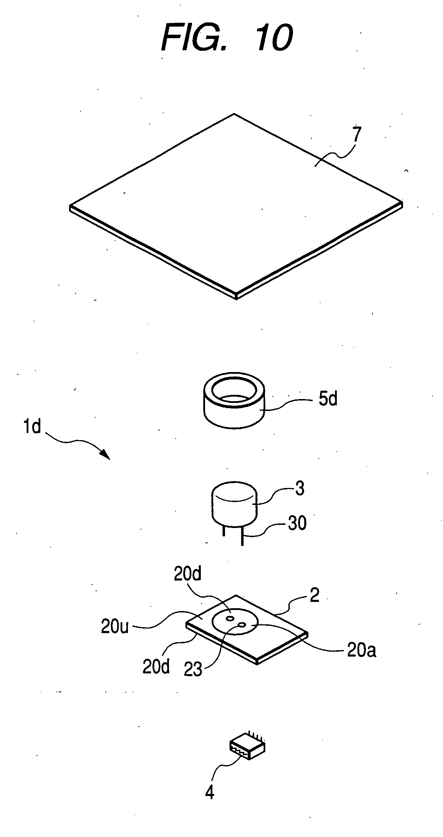

The structure of a conductor detecting switch 1d in a fourth embodiment of this invention will now be described with reference to Fig. 10. In the conductor detecting switch 1d in the fourth embodiment, an electrode 20d is provided which has no hollow part therein and has a size corresponding to the size of an LED 3. The electrode 20d is provided substantially on the entire lower side of the LED 3 and the LED 3 is caused to function as a dielectric member. A member having the same structure as the dielectric member 5 in the first embodiment is provided as a supporting member 5d for supporting a control board 2. Using this supporting member 5d and a fixture, not shown, the control board 2 is supported on an operating panel 7.

With this structure, the area of the electrode can be increased because no hollow part is provided therein. Moreover, even if the large area of the electrode is secured in this manner, the conductor detecting switch 1d can be made compact as a whole.

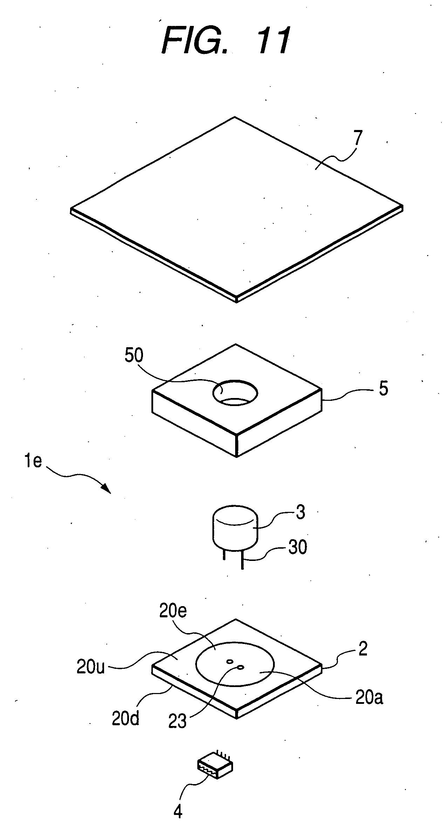

In the case of providing the electrode 20d on the lower side of the LED 3, a structure in which an electrode 20e is exposed on the outside of the LED 3 may be employed, as shown in Fig. 11. A dielectric member 5 similar to the dielectric member in the first embodiment may be attached on the exposed part of the electrode, and a diffusion plate may be provided on the top of a through-hole 50 in the dielectric member 5 as in the second embodiment.. Alternatively, electrodes may be provided in an array as in the third embodiment so as to enable simplification of the manufacturing process.

The conductor detecting switch of this invention includes a flat board and an electrode provided on the board and having a detection surface facing an approaching direction of a conductor as a detection object, and is adapted for detecting electrostatic capacity of the electrode and thus detecting approach of the conductor. In the conductor detecting switch, an electronic component which is a dielectric member is provided on the electrode. Therefore, the electronic component can be provided to overlap the electrode. The switch can be made compact and the occupied area on the operating panel can be reduced. Moreover, since the electronic component, which is a dielectric member, is provided on the electrode, high detection sensitivity to the conductor can be realized even when the electrode is provided below the electronic component and thus away from the operating panel.

## Claims

1. A conductor detecting switch comprising a flat board and an electrode provided on the board and having a detection surface facing an approaching direction of a conductor as a detection object, the conductor detecting switch being adapted for detecting electrostatic capacity of the electrode and thus detecting approach of the conductor,
wherein an electronic component which is a dielectric member is provided on the electrode.

2. The conductor detecting switch as claimed in claim 1, wherein an electronic component which is a dielectric member is provided on the electrode, and a dielectric member different from the electronic component is provided on the outside of the electronic component on the electrode.

3. The conductor detecting switch as claimed in claim 1, wherein the board is a printed board and the electrode is formed by the printed board.

4. The conductor detecting switch as claimed in claim 1, wherein the electronic component is an LED, the LED being provided at a central part of the electrode, and a through-hole corresponding to the outer shape of the LED is provided in the dielectric member so that the dielectric member covers the outer circumference of the LED.

5. The conductor detecting switch as claimed in claim 3, wherein a diffusion plate is provided above the LED housed in through-hole.

6. A conductor detecting switch as claimed in claim 1, wherein plural electrodes are provided on a board, each of the electrodes having an electronic component provided at its central part, and a single dielectric member is provided on the electrodes.
